# EUROPÄISCHE PATENTSCHRIFT

(11) **EP 2 034 572 B1**
(45) Veröffentlichungstag und Bekanntmachung des Hinweises auf die Patenterteilung: **24.05.2017**
(21) Anmeldenummer: 07115871.1
(22) Anmeldetag: 07.09.2007
(51) Int. Cl.: H01S 5/40, B23K 26/06

(54) **Laserdioden-Anordnung**
Laser diode assembly
Agencement de diodes laser

(43) Veröffentlichungstag der Anmeldung: 11.03.2009
(73) Patentinhaber: iie Gesellschaft für innovative Industrieelektronik mbH, 83564 Soyen (DE)
(72) Erfinder: Kress, Ekkehard, iie, 83512, Wasserburg am Inn (DE)
(74) Vertreter: Oberhardt, Knut

(56) Entgegenhaltungen:
- EP-A- 0 525 684
- EP-A- 0 950 973
- EP-A- 1 450 454
- WO-A-2007/055691
- US-A- 6 137 816

## Beschreibung

Die Erfindung betrifft eine Laserdioden-Anordnung nach dem Oberbegriff von Anspruch 1.

Um große Laserleistungen mit preisgünstigen Bauteilen zu erreichen werden mit Hilfe der Wafer-Technik so genannte Laserbarren hergestellt. Solche Barren werden durch streifenförmige Chips gebildet, die mehrere Einzelemitter nebeneinander enthalten. Die Einzelemitter sind elektrisch parallel geschaltet. Der streifenförmige Chip wird üblicherweise auf eine Wärmesenke montiert.

Ein Laserbarren enthält ca. 50 Einzelemitter, die jeweils einen Laserstrahl emittieren, der in der einen Richtung (fast axis) ca. 40° und in der anderen Richtung (slow axis) ca. 12° Abstrahlwinkel aufweist. Über Kollimationslinsen werden die Einzelstrahlen zusammengefasst.

Um noch höhere Laserleistungen zu erreichen werden solche Laserbarren zu so genannten Stacks gestapelt. Je nach Anwendung sind horizontale wie auch vertikale Stacks bekannt geworden. In diesen Stacks werden die einzelnen Laserbarren elektrisch in Reihe geschaltet. Mit solchen Stacks lassen sich optische Leistungen von ca. 1 kW erzeugen. Aufgrund der hohen Packungs- und Leistungsdichte werden die einzelnen Barren wiederum auf Wärmesenken montiert, die mit Wasser gekühlt werden können.

Aus der US 6,137,816 A geht eine Anordnung hervor, in der eine Anzahl von in Reihe geschalteten Laserdioden zum Pumpen eines YAG-Lasers verwendet wird. Zu einer oder mehreren Laserdioden ist jeweils über einen Transistor ein Bypass geschaltet. Die Transistoren werden gemeinsam so angesteuert, dass der Versorgungsstrom entweder über die Laserdioden oder über den Bypass fließt. Auf diese Weise lassen sich kurze Strom-Impulse mit sehr steilen Flanken realisieren.

Der zusammengefasste Strahl von Hochleistungs-Diodenlaser weist jedoch keine sehr große Homogenität auf. Dies ist auf produktionstechnische Toleranzen und unterschiedliche Strom-Lichtleistungs-Kennlinien der einzelnen Laserbarren, aber auch auf ein unterschiedliches Alterungsverhalten zurückzuführen. Da für eine große Anzahl von Anwendungen jedoch eine hohe Homogenität des Strahls erforderlich ist, werden oftmals teure und aufwändige Korrekturen auf optischem Wege vorgenommen, um die Homogenität des Strahls zu erhöhen.

Der Erfindung liegt die Aufgabe zugrunde, eine solche Laseranordnung so zu gestalten, dass die Homogenität des Laserstrahls auf elektrischem Wege verbessert und dass bei unterschiedlicher Alterung ebenfalls elektrisch nachgesteuert werden kann. Eine weitere Aufgabe der Erfindung ist es, das Strahlungs-Profil je nach Anwendung beeinflussen zu können und so einen Laserstrahl zu generieren, der bewusst ein inhomogenes Strahlungs-Profil aufweist.

Gelöst wird die Aufgabe gemäß der Erfindung durch eine Laserdioden-Anordnung mit den Merkmalen von Anspruch 1. Erfindungsgemäß ist zu jeder Laserdiode oder jedem Laserbarren ein Bypass geschaltet, über den die Lichtleistung der Laserdiode oder des Laserbarrens steuerbar ist. Über den Bypass lässt sich nun - trotz der Reihenschaltung der Laserbarren - jeder Laserbarren einzeln steuern. Die Steuerung der Laserbarren erfolgt dabei indirekt. Der wirksame Strom durch jeden Laserbarren ergibt sich aus der Differenz zwischen dem Stromwert der anliegenden Stromquelle und dem gesteuerten Strom, der durch den Bypass geführt wird. Ein Laserbarren lässt sich sogar soweit über den Bypass kurzschließen, dass der Strom durch den Laserbarren unterhalb des Schwellstroms bleibt. Auf diese Weise lässt sich ein beliebiges Intensitätsprofil der Strahlung erzeugen. Dieses Intensitätsprofil kann auch so gewählt werden, dass die Strahlung weitgehend homogen ist.

Der Strom über den Bypass wird erfindungsgemäß mit einem Feldeffekttransistor (FET) insbesondere mit einem PowerFET gesteuert. Ein PowerFET ist ein heute preiswert verfügbares Bauteil, welches auch für die sehr hohen zu schaltenden Ströme verfügbar ist.

Um jede Laserdiode oder jeden Laserbarren so anzusteuern, dass sich seine Lichtleistung nicht verändert, könnte ein Regelungssystem vorgesehen werden, bei dem die Lichtleistung ständig überprüft wird. Dies ist jedoch sehr aufwändig, da hierfür aus dem Strahl jeder Laserdiode oder jedes Laserbarrens Licht ausgekoppelt werden müsste. Über einen Fotosensor könnte dann die jeweilige Steuerung vorgenommen werden.

Erfindungsgemäß ist jedoch in jedem Bypass ein Strommesswiderstand vorgesehen. Auf diese Art und Weise kann die Laserdiode oder der Laserbarren mit einem vorbestimmten Strom versorgt werden. Hierdurch lassen sich Änderungen der Lichtleistung bei Temperaturänderungen kompensieren, da der Stromfluss nicht mehr von dem temperaturabhängigen Widerstand der Laserdiode oder des Laserbarrens abhängt, sondern exakt gesteuert werden kann.

Um den Versorgungsstrom für jede Laserdiode oder jeden Laserbarren zu steuern ist eine Bypasssteuerung vorgesehen. Diese Bypasssteuerung kann in eine Systemsteuerung integriert sein. Mit dieser Bypasssteuerung ist der jeweilige FET und der entsprechende Strommesswiderstand verbunden. Es entsteht so jeweils ein Regelkreis, dessen Soll-Wert in der Bypasssteuerung hinterlegt ist, während der Ist-Wert von dem Strommesswiderstand geliefert wird. Vorteilhaft ist für jeden Bypass eine eigene Bypasssteuerung vorgesehen.

Die Bypasssteuerungen sind in vorteilhafter Weise mit einer Systemsteuerung verbunden. Da vorteilhaft für jeden Bypass eine eigene Bypasssteuerung vorgesehen ist, bildet die Systemsteuerung die Verbindung zwischen den einzelnen Bypasssteuerungen und ist für den Abgleich der Bypasssteuerungen verantwortlich.

Jede Bypasssteuerung kann einen Speicher aufweisen, in dem eine Strom-Lichtleistungs-Kennlinie hinterlegt ist. Diese Kennlinie wird für jede Laserdiode oder jeden Laserbarren einzeln ausgemessen. Es wird auf diese Weise möglich, jede Laserdiode oder jeden Laserbarren so anzusteuern, dass eine vorbestimmte Lichtleistung abgegeben wird. Besonders vorteilhaft sind diese Lichtleistungs-Kennlinien jedoch in der Systemsteuerung hinterlegt, da auf diese Weise die Bypasssteuerungen sehr einfach und preiswert ohne Datenspeicher ausgelegt werden können.

Von der Systemsteuerung wird auch eine steuerbare Stromquelle zur Versorgung der Laserdioden oder Laserbarren angesteuert. Auf diese Weise lässt sich die Gesamtleistung der Laserdioden-Anordnung an verschiedene Anwendungen anpassen.

In einem vorteilhaften Ausführungsbeispiel wird ein Stack verwendet, der aus horizontal gestapelten Laserbarren gebildet wird. Durch diesen Stack wird ein schmales Strahlungsband mit sehr hoher Strahlungsintensität erzeugt, das auf eine dünne Linie projizierbar ist.

Eine solche Laserdioden-Anordnung kann beispielsweise zum Härten von Werkstücken oder von Werkstückoberflächen verwendet werden.

Vorteilhaft wird die Linie weitgehend homogen ausgeleuchtet. Hierzu gibt die Systemsteuerung jeder Bypasssteuerung einen Wert für die geforderte Lichtleistung vor. Über die hinterlegte Kennlinie wird von der Bypasssteuerung die dazugehörige Stromstärke eingestellt.

Bei einem erfindungsgemäßen Einmessverfahren für die Laserdioden-Anordnung werden die Laserdioden oder Laserbarren nacheinander einzeln mit dem höchsten zulässigen Strom betrieben und deren Lichtleistung beispielsweise über einen Fotosensor gemessen. Danach wird die Lichtleistung aller Laserdioden oder Laserbarren auf die geringste gemessene Lichtleistung eingestellt. Bei Verwendung dieses Einmessverfahrens lässt sich mit der Laserdioden-Anordnung eine sehr homogene Strahlung erzeugen. Die homogene Strahlung wird mit der maximalen Leistung der Laserdioden-Anordnung erzielt. Das Einmessverfahren ist sehr schnell durchzuführen, aber nur auf diesen Anwendungszweck ausgerichtet.

Soll die Laserdioden-Anordnung nicht mit ihrer maximalen Leistung betrieben werden oder soll keine homogene Strahlung sondern ein vorbestimmtes Strahlungs-Profil erzeugt werden, wird ein anderes Einmessverfahren bevorzugt. Bei diesem bevorzugten Einmessverfahren wird wiederum jede Laserdiode oder jeder Laserbarren einzeln vermessen und es wird dabei für jede Laserdiode oder jeden Laserbarren eine Strom-Lichtleistungs-Kennlinie aufgenommen und in der betreffenden Bypasssteuerung hinterlegt.

In vorteilhafter Weise wird der Versorgungsstrom für die in Reihe geschalteten Laserdioden oder Laserbarren indirekt über den Bypassstrom gesteuert. Das bedeutet, dass die Einstellung der Lichtleistung für jede Laserdiode oder jeden Laserbarren durch die Bypasssteuerung über den Feldeffekttransistor und den Strommesswiderstand in dem jeweiligen Bypass erfolgt.

Für eine große Zahl von Anwendungsfällen wird eine homogene Strahlung benötigt. In diesem Fall wird der Versorgungsstrom für jede Laserdiode oder jeden Laserbarren so eingestellt, dass jede Laserdiode oder jeder Laserbarren dieselbe Lichtleistung abgibt. Dabei kann sich der Versorgungsstrom für jede Laserdiode oder jeden Laserbarren entsprechend der jeweiligen Strom-Lichtleistungs-Kennlinie, die während des Einmessverfahrens aufgenommen wurde, unterscheiden.

Es sind jedoch auch Anwendungsfälle erkennbar, bei denen keine homogene Strahlung sondern, aufgrund bestimmter Werkstückgeometrien, ein entsprechendes Strahlungs-Profil erwünscht ist. In diesem Fall wird der Versorgungsstrom für jede Laserdiode oder jeden Laserbarren so eingestellt, dass die Lichtleistung nach einem in der Systemsteuerung abgelegten Intensitäts-Profil eingestellt wird.

Bei einem weiteren Anwendungsfall wird ein Objekt, z. B. ein zu härtendes Werkstück mit bestimmter Geometrie relativ zu der Strahlung bewegt. In diesem Fall ist es nicht ausreichend, ein vorbestimmtes Strahlungs-Profil zu erzeugen, sondern das Strahlungs-Profil muss kontinuierlich mit der Relativbewegung zwischen Werkstück und Strahlungsquelle verändert werden. Zu diesem Zweck wird in der Systemsteuerung ein Werkstück-Profil hinterlegt und das Strahlungs-Profil wird kontinuierlich an das Werkstück-Profil angepasst. Hierzu wird das Werkstück-Profil zu einem dreidimensionalen Intensitäts-Kennfeld verrechnet. Zur genauen Steuerung des Strahlungs-Profils ist noch ein Positionsgeber erforderlich, der entweder die Position der Strahlungsquelle oder die Position des Werkstücks erfasst. Auf diese Weise lässt sich eine dreidimensionale Steuerung der Strahlung der Laserdioden-Anordnung realisieren.

In ähnlicher Weise wird verfahren, wenn beispielsweise Druckfarbe auf einem Objekt getrocknet werden soll. Es sind heute Druckmaschinen bekannt, in denen das zu bedruckende Objekt eine Vielzahl einzelner Druckwerke nacheinander durchläuft. Üblicherweise wird nach jedem Druckwerk die aufgebrachte Farbe getrocknet. In der Systemsteuerung wird zu diesem Zweck das Druckprofil des jeweiligen Druckwerks hinterlegt. Auf diese Weise wirkt die hochenergetische Strahlung nur auf die Bereiche des bedruckten Objekts, auf die in dem betroffenen Druckwerk auch tatsächlich Farbe aufgebracht worden ist. Die in diesem Druckwerk nicht bedruckten Bereiche werden auch in der Trocknungsstufe nicht bestrahlt. Durch diese Maßnahme kann auf die bedruckten Bereiche eine sehr hohe Trocknungsenergie aufgebracht werden, ohne dass nicht bedrucktes Material dabei beschädigt wird.

Wird z. B. in einem Druckwerk gelbe Farbe auf eine schwarze Folie aufgebracht, so kann bei einer flächendeckenden Trocknung nur soviel Energie eingebracht werden, dass die nicht bedruckten Bereiche der schwarzen Folie nicht zu schmelzen oder zu verdampfen beginnen. Wird die Trocknung dagegen mit der erfindungsgemäßen Laserdioden-Anordnung auf die mit der gelben Farbe bedruckten Bereiche beschränkt, können selektiv diese Bereiche einer wesentlich stärkeren Strahlung ausgesetzt werden. Auf diese Weise lässt sich gegenüber herkömmlichen Trocknern entweder die Trocknungsstrecke verkürzen oder aber die Durchlaufgeschwindigkeit erhöhen.

Ebenso kann bei der selektiven Farbtrocknung auch die Dicke des Farbauftrags berücksichtigt werden. Hierzu wird die jeweilige Auftragsstärke in das in der Systemsteuerung hinterlegte Druckprofil eingearbeitet. Es entsteht so ein dreidimensionales Druckprofil, nach dem die Laseranordnung gesteuert wird.

Weitere Einzelheiten und Vorteile der Erfindung ergeben sich aus den Unteransprüchen in Zusammenhang mit der Beschreibung eines Ausführungsbeispiels, das anhand der Zeichnung eingehend erläutert wird.

Es zeigt:

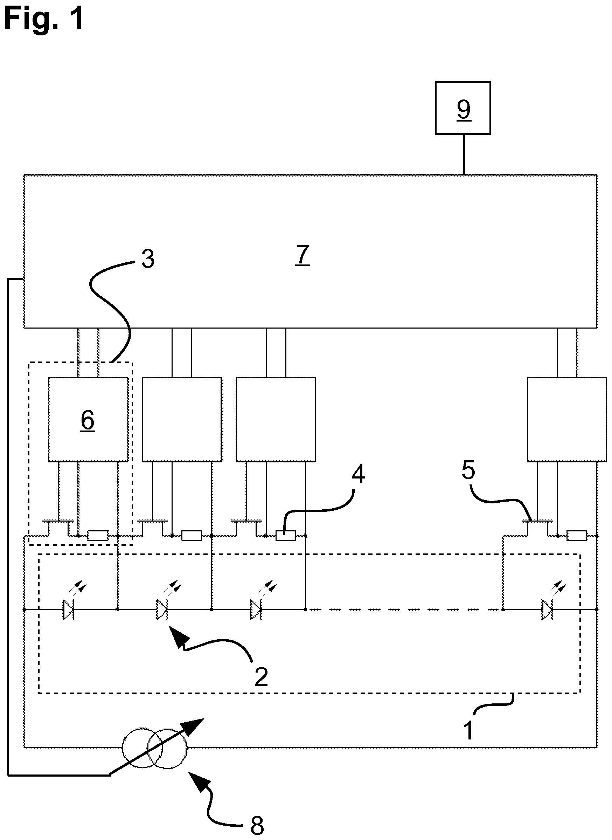

- Fig. 1: eine Versorgungsschaltung für die erfindungsgemäße Laserdioden-Anordnung.

Die gezeigte Schaltung weist eine Systemsteuerung 7 auf, die direkt oder indirekt mit allen dargestellten Bauteilen verbunden ist. Mit dem Bezugszeichen 2 sind einzelne Laserbarren bezeichnet, die zwischen zehn und hundert Laserdioden aufweisen und sich ähnlich wie eine einzelne große Laserdiode verhalten. Die einzelnen Laserbarren 2 sind zu einem horizontal gestapelten Stack 1 zusammengefasst und üblicherweise auf einer mit Mikrokanälen versehenen Wärmesenke montiert. Zur Kühlung wird durch die Mikrokanäle Wasser gepumpt. So ein horizontal gestapelter Stack eignet sich hervorragend zur Erzeugung einer sehr schmalen Laserlinie.

Jeweils parallel zu einem Laserbarren 2 ist ein steuerbarer Bypass 3 geschaltet. Dieser steuerbare Bypass 3 besteht hauptsächlich aus einem Strommesswiderstand 4 und einem PowerFET 5. Auch die Bypasssteuerung 6 ist dem steuerbaren Bypass 3 zuzurechnen. Die Bypasssteuerung 6 ist so mit dem Bypass 3 verbunden, dass die an dem Strommesswiderstand 4 abfallende Spannung gemessen und in den Stromwert umgerechnet werden kann. Ebenso wird von der Bypasssteuerung 6 der PowerFET 5 so angesteuert, dass der gewünschte Strom durch den Bypass 3 fließt. Über diese Steuerung des Bypassstroms wird folglich indirekt der durch die Laserbarren 2 fließende Strom gesteuert.

Der Gesamtstrom für alle Laserbarren 2 wird über die steuerbare Stromquelle 8 geliefert. Diese ist ebenso wie die Bypasssteuerungen 6 mit der Systemsteuerung 7 verbunden. Weiterhin ist noch ein Positionsgeber 9 vorgesehen, der seine Werte ebenfalls an die Systemsteuerung 7 übergibt.

Die erfindungsgemäße Laserdioden-Anordnung muss bei Inbetriebnahme und danach in bestimmten Zeitabständen eingemessen werden. Bei diesem Einmessvorgang wird jeweils nur einer der Laserbarren 2 mit einem Strom beaufschlagt, der oberhalb des Schwellstroms liegt. Hierzu werden die anderen Laserbarren über den jeweiligen Bypass praktisch kurzgeschlossen, wobei fast der vollständige Stromfluss über den Bypass geführt wird und der Stromfluss durch den Laserbarren unterhalb des Schwellstroms bleibt. Auf diese Weise ist nur immer ein Laserbarren aktiv und kann ohne Störeinflüsse von den anderen Laserbarren vermessen werden. Über einen Lichtsensor wird nun bei dem aktiven Laserbarren eine Strom-Lichtleistungs-Kennlinie aufgenommen. Diese Kennlinie wird in der dazugehörigen Bypasssteuerung abgespeichert.

Auf diese Weise wird für jeden Laserbarren 2 die entsprechende Kennlinie aufgenommen und in der jeweiligen Bypasssteuerung 6 abgespeichert. Sind alle Kennlinien hinterlegt, ist die Laserdioden-Anordnung einsatzbereit. Soll mit der Laserdioden-Anordnung eine homogene Linie erzeugt werden, wird der gewünschte Intensitätswert in die Systemsteuerung 7 eingegeben. Diese steuert die Stromquelle 8 so an, dass der Laserbarren mit dem geringsten Wirkungsgrad noch die gewünschte Intensität erreicht. Der Wirkungsgrad lässt sich für jeden Versorgungsstrom anhand der Kennlinie für jeden Laserbarren ermitteln. Sollte diese Stromstärke über der zulässigen Stromstärke zum Betreiben der Laserbarren liegen, wird eine entsprechende Warnung ausgegeben. Im anderen Fall wird über die Bypasssteuerungen 6 der Stromfluss über den jeweiligen Bypass mit dem PowerFET 5 und dem Strommesswiderstand 4 so gesteuert, dass von allen Laserbarren die gleiche Lichtleistung abgegeben wird. Der entsprechende Stromwert wird aus der jeweils hinterlegten Kennlinie abgeleitet.

Soll nun beispielsweise ein Werkstück gehärtet werden, welches unterschiedliche Dicke aufweist, wird in der Steuerung 7 das dreidimensionale Dickenprofil des Werkstücks abgelegt. Während nun das Werkstück relativ zu der Laserlinie bewegt wird, erhält die Steuerung 7 über den Positionsgeber 9 zu jedem Zeitpunkt die genaue Position des Werkstücks. Anhand des dreidimensionalen Dickenprofils errechnet die Steuerung 7 den für jeden Bereich des Werkstückes notwendigen Betrag an Lichtleistung. Diese jeweils erforderliche Lichtleistung wird von den einzelnen Bypasssteuerungen 6 anhand der hinterlegten Kennlinie in den jeweils notwendigen Stromwert umgesetzt. Das Intensitätsprofil des linienförmigen Laserstrahls wird auf diese Weise ständig an das Dickenprofil des Werkstücks angepasst. Es kann so eine vollkommen gleichmäßige Härtung erfolgen.

### Bezugszeichenliste:

- 1: horizontal gestapelter Stack
- 2: Laserbarren
- 3: steuerbarer Bypass
- 4: Strommesswiderstand
- 5: PowerFET
- 6: Bypasssteuerung
- 7: Systemsteuerung
- 8: steuerbare Stromquelle
- 9: Positionsgeber

## Patentansprüche

1. Laserdioden-Anordnung zur Erzeugung einer Strahlung mit vorgegebenem Intensitätsprofil, mit einer Anzahl von Laserdioden oder Laserbarren (2), die zu einem horizontalen oder vertikalen Stack (1) gestapelt sind, wobei die Laserdioden oder Laserbarren (2) in dem Stack (1) elektrisch in Reihe geschaltet sind, **dadurch gekennzeichnet, dass** zu jeder Laserdiode oder jedem Laserbarren (2) ein Bypass (3) geschaltet ist, über den die Lichtleistung der Laserdiode oder des Laserbarrens (2) steuerbar ist, wobei der Bypass (3) einen Feldeffekttransistor (5) enthält und einen Strommesswiderstand (4) aufweist, wobei der Feldeffekttransistor (5) und der Strommesswiderstand (4) mit einer Bypasssteuerung (6) in Verbindung stehen und wobei eine Strom-Lichtleistungs-Kennlinie für jede Laserdiode oder jeden Laserbarren (2) hinterlegt ist und der Versorgungsstrom für jede Laserdiode oder jeden Laserbarren (2) so einstellbar ist, dass die Lichtleistung nach dem vorgegebenen Intensitäts-Profil eingestellt wird.

2. Laserdioden-Anordnung nach Anspruch 1, **dadurch gekennzeichnet, dass** die Bypasssteuerung (6) mit einer Systemsteuerung (7) verbunden ist.

3. Laserdioden-Anordnung nach Anspruch 1, **dadurch gekennzeichnet, dass** die Strom-Lichtleistungs-Kennlinie für jede Laserdiode oder jeden Laserbarren (2) in der Systemsteuerung (7) hinterlegt ist.

4. Laserdioden-Anordnung nach Anspruch 3, **dadurch gekennzeichnet, dass** von der Systemsteuerung (7) eine steuerbare Stromquelle (8) zur Versorgung der Laserdioden oder der Laserbarren (2) angesteuert wird.

5. Laserdioden-Anordnung nach Anspruch 1, **dadurch gekennzeichnet, dass** die Strahlung auf eine Linie projizierbar ist.

6. Laserdioden-Anordnung nach Anspruch 5, **dadurch gekennzeichnet, dass** die Linie weitgehend homogen ausgeleuchtet ist.

7. Einmessverfahren für eine Laserdioden-Anordnung nach Anspruch 1, **dadurch gekennzeichnet, dass** die Laserdioden oder Laserbarren (2) nacheinander einzeln mit dem höchsten zulässigen Strom betrieben und deren Lichtleistung gemessen wird und die Lichtleistung aller Laserdioden oder Laserbarren (2) auf die geringste gemessene Lichtleistung eingestellt wird.

8. Einmessverfahren für eine Laserdioden-Anordnung nach Anspruch 1, **dadurch gekennzeichnet, dass** für jede Laserdiode oder jeden Laserbarren (2) eine Strom-Lichtleistungs-Kennlinie aufgenommen wird.

9. Verfahren zur Steuerung einer Laserdioden-Anordnung nach Anspruch 1, **dadurch gekennzeichnet, dass** die Einstellung der Lichtleistung über den Versorgungsstrom für jede Laserdiode oder jeden Laserbarren (2) durch die Bypasssteuerung (6) über den Feldeffekttransistor (5) und den Strommesswiderstand (4) in dem jeweiligen Bypass (3) erfolgt.

10. Verfahren nach Anspruch 9, **dadurch gekennzeichnet, dass** der Versorgungsstrom für jede Laserdiode oder jeden Laserbarren (2) so eingestellt wird, dass jede Laserdiode oder jeder Laserbarren (2) die selbe Lichtleistung abgibt.

11. Verfahren nach Anspruch 9, **dadurch gekennzeichnet, dass** das vorgegebene Intensitäts-Profil in der Systemsteuerung (7) abgelegt wird.

12. Verfahren nach Anspruch 11, **dadurch gekennzeichnet, dass** in der Systemsteuerung (7) ein Objekt-Profil eingelesen und zu einem dreidimensionalen Intensitäts-Kennfeld verrechnet wird.

## Claims

1. A laser diode array for generating a radiation with a predefined intensity profile, comprising a number of laser diodes or laser bars (2), which are stacked, forming a horizontal or vertical stack (1), wherein the laser diodes or laser bars 2) in the stack are electrically connected in series, **characterised in that** a bypass (3) is connected to each laser diode or each laser bar (2), via which the light-output of the laser diode or laser bar (2) can be controlled, wherein the bypass (3) contains a field effect transistor (5) and comprises a current-sensing resistor (4), wherein the field effect transistor (5) and the current-sensing resistor (4) are in communication with a bypass control (6), and wherein a current-light-output characteristic for each laser diode or each laser bar (2) is stored in such a way that the light-output is adjusted in accordance with the predefined intensity profile.

2. The laser diode array according to claim 1, **characterised in that** the bypass control (6) is connected to a system control (7).

3. The laser diode array according to claim 1, **characterised in that** the current-light-output characteristic for each laser diode or each laser bar (2) is stored in the system control (7).

4. The laser diode array according to claim 3, **characterised in that** a controllable current source (8) is activated by the system control (7) for supplying power to the laser diodes or laser bars (2).

5. The laser diode array according to claim 1, **characterised in that** the radiation can be projected onto a line.

6. The laser diode array according to claim 5, **characterised in that** the line is largely uniformly illuminated.

7. A calibration method for a laser diode array according to claim 1, **characterised in that** the laser diodes or laser bars (2) are operated individually in sequence, with the maximum admissible current and their light-output being measured, and the light-output of all laser diodes or laser bars (2) being set to the lowest measured light-output.

8. The calibration method for a laser diode array according to claim 1, **characterised in that** a current-light-output characteristic is recorded for each laser diode or each laser bar (2).

9. A method for controlling a laser diode array according to claim 1, **characterised in that** setting the light-output via the supply current for each laser diode or laser bar (2) is effected by the bypass control (6) via the field effect transistor (5) and the current-sensing resistor (4) in the respective bypass (3).

10. The method according to claim 9, **characterised in that** the supply current for each laser diode or each laser bar (2) is set such that each laser diode or each laser bar (2) emits the same light-output.

11. The method according to claim 9, **characterised in that** the predefined intensity profile is stored in the system control (7).

12. The method according to claim 11, **characterised in that** an object profile is read into the system control (7) and adapted to obtain a three-dimensional diagram.

## Revendications

1. Dispositif de diodes laser pour la production d'un rayonnement avec un profil d'intensité prédéfini, avec un nombre de diodes laser ou de barres laser (2), qui sont empilées en une pile horizontale ou verticale (1), dans lequel les diodes laser ou les barres laser (2) sont branchées électriquement en série dans la pile (1), **caractérisé en ce que** pour chaque diode laser ou chaque barre laser (2) est branchée une dérivation (3), par laquelle peut être commandée la puissance lumineuse de la diode laser ou de la barre laser (2), dans lequel la dérivation (3) comprend un transistor à effet de champ (5) et présente une résistance de courant (4), dans lequel le transistor à effet de champ (5) et la résistance de courant (4) sont en liaison avec une commande de dérivation (6) et dans lequel une caractéristique courant - puissance lumineuse est consignée pour chaque diode laser ou chaque barre laser (2) et le courant d'alimentation peut être réglé pour chaque diode laser ou chaque barre laser (2) de manière telle que la puissance lumineuse est réglée selon le profil d'intensité prédéfini.

2. Dispositif de diodes laser selon la revendication 1, **caractérisé en ce que** la commande de dérivation (6) est reliée à une commande du système (7).

3. Dispositif de diodes laser selon la revendication 1, **caractérisé en ce que** la caractéristique courant - puissance lumineuse est consignée pour chaque diode laser ou chaque barre laser (2) dans la commande du système (7).

4. Dispositif de diodes laser selon la revendication 3, **caractérisé en ce qu'**une source de courant (8) pouvant être commandée par la commande du système (7) est commandée pour alimenter les diodes laser ou les barres laser (2).

5. Dispositif de diodes laser selon la revendication 1, **caractérisé en ce que** le rayonnement peut être projeté sur une ligne.

6. Dispositif de diodes laser selon la revendication 5, **caractérisé en ce que** la ligne est éclairée en grande partie d'une manière homogène.

7. Procédé d'étalonnage pour un dispositif de diodes laser selon la revendication 1, **caractérisé en ce que** les diodes laser ou barres laser (2) sont actionnées individuellement les unes après les autres avec le courant admissible le plus élevé et leur puissance lumineuse est mesurée et la puissance lumineuse de toutes les diodes laser ou barres laser (2) est réglée sur la puissance lumineuse mesurée la plus faible.

8. Procédé d'étalonnage pour un dispositif de diodes laser selon la revendication 1, **caractérisé en ce que** pour chaque diode laser ou chaque barre laser (2) est enregistrée une caractéristique courant - puissance lumineuse.

9. Procédé pour commander un dispositif de diodes laser selon la revendication 1, **caractérisé en ce que** le réglage de la puissance lumineuse est réalisé au moyen du courant d'alimentation pour chaque diode laser ou chaque barre laser (2) par la commande de dérivation (6) par le biais du transistor à effet de champ (5) et de la résistance de courant (4) dans la dérivation respective (3).

10. Procédé selon la revendication 9, **caractérisé en ce que** le courant d'alimentation pour chaque diode laser ou chaque barre laser (2) est réglé de manière telle que chaque diode laser ou chaque barre laser (2) dégage la même puissance lumineuse.

11. Procédé selon la revendication 9, **caractérisé en ce que** le profil d'intensité prédéfini est placé dans la commande du système (7).

12. Procédé selon la revendication 11, **caractérisé en ce qu'**un profil d'objet est lu dans la commande du système (7) et est pris en compte pour un diagramme caractéristique d'intensité à trois dimensions.
